# FASCICULE DE BREVET EUROPEEN

(11) **EP 4 298 660 B1**
(45) Date de publication et mention de la délivrance du brevet: **17.07.2024**
(21) Numéro de dépôt: 22708987.7
(22) Date de dépôt: 14.02.2022
(51) Int. Cl.: H01L 21/02, H01L 21/762

(54) **PROCÉDÉ DE PRÉPARATION DU RÉSIDU D'UN SUBSTRAT DONNEUR AYANT SUBI UN PRÉLÈVEMENT D'UNE COUCHE PAR DÉLAMINATION**
VERFAHREN ZUR HERSTELLUNG DES RESTS EINES DONORSUBSTRATS, DESSEN SCHICHT DURCH DELAMINATION ENTFERNT WURDE
METHOD FOR PREPARING THE RESIDUE OF A DONOR SUBSTRATE, A LAYER OF WHICH HAS BEEN REMOVED BY DELAMINATION

(30) Priorité: 23.02.2021 FR 2101738
(43) Date de publication de la demande: 03.01.2024
(73) Titulaire: SOITEC, 38190 Bernin (FR)
(72) Inventeur: HUYET, Isabelle, 38190 Bernin (FR); CAPELLO, Luciana, 38190 Bernin (FR)
(74) Mandataire: IP Trust
(86) Numéro de dépôt international: PCT/FR2022/050260
(87) Numéro de publication internationale: WO 2022/180321

(56) Documents cités:
- EP-A1- 1 427 001
- US-A1- 2011 140 244
- US-A1- 2018 033 609

## Description

### DOMAINE DE L'INVENTION

La présente invention concerne un procédé de préparation d'un résidu de substrat donneur.

### ARRIERE PLAN TECHNOLOGIQUE DE L'INVENTION

Le document US20200186117 décrit un procédé de préparation d'une couche mince qui comprend la formation préliminaire d'un substrat donneur composite constitué d'une couche épaisse d'un matériau sur un support intermédiaire, le prélèvement d'une couche mince dans la couche épaisse du substrat donneur et son report sur un support final. Le prélèvement et le report sont mis en oeuvre par l'intermédiaire de la technologie Smart Cut^{™}.

Ce procédé de préparation est particulièrement approprié lorsque le matériau constituant la couche mince présente un coefficient de dilatation thermique bien différent de celui constituant le support final.

Les étapes de prélèvement et de report de la couche mince comprennent l'introduction d'espèces légères dans le substrat donneur, ici dans la couche épaisse du substrat donneur composite, à travers une face (ou surface) dite « principale » de ce substrat afin de constituer un plan fragile enterré. La couche à reporter est définie entre ce plan fragile enterré et la surface principale du substrat donneur. Dans une étape suivante, le substrat donneur est assemblé par sa face principale au support final, et on applique un traitement thermique de l'ensemble, éventuellement complété par l'application d'efforts mécaniques, pour détacher la couche mince au niveau du plan fragile et la reporter sur le support final.

Le résidu du substrat donneur, c'est-à-dire la partie restante de ce substrat après que la couche mince ait été prélevée, peut être reconditionné afin d'être exploité dans un autre cycle de prélèvement - reconditionnement. On connaît de tels procédés de reconditionnement d'un résidu obtenu à l'issue du procédé Smart Cut^{™}, par exemple documents EP1427002, EP1427001, US20090061545, US20100200854, US20180033609. Ces procédés cherchent généralement à éliminer une marche périphérique, souvent désignée couronne, correspondant à la portion périphérique du substrat donneur non transférée sur le support final, et à préparer la surface principale du résidu pour éliminer les défauts de surface engendrés par la fracture du matériau au niveau du plan fragile.

Dans le cas du procédé proposé dans le document US20200186117, la couche épaisse et le support intermédiaire présentant des coefficients de dilatation thermique différents, le substrat donneur composite tend à présenter une courbure lui donnant une force généralement convexe, la surface principale (la face exposée de la couche épaisse) de ce substrat étant légèrement courbée vers l'extérieur.

Lorsque l'étape d'assemblage est réalisée par adhésion moléculaire, le substrat donneur est mis en contact avec le support final au niveau du sommet de la convexité, situé dans une portion centrale de la surface principale de ce substrat. On initie ensuite une onde de collage tendant à mettre en contact les deux surfaces qui se font face, cette onde se propageant concentriquement du point de contact initial vers les bords extérieur du substrat donneur et du support final.

Une telle configuration tend à faire apparaître des défauts de collage à l'interface entre le substrat donneur et le support final, ces défauts se présentant sous la forme de bulles de petites dimensions disposées proches des bords de l'assemblage, à l'extrémité de propagation de l'onde de collage. Ces bulles préviennent localement la bonne adhésion du substrat donneur au support final, et en conséquence les portions de la couche mince surplombant ces défauts ou leurs voisinages ne sont pas parfaitement prélevées et reportées sur le support final. La couche mince présente donc à son tour des défauts, de type « trou », ou un contour très irrégulier.

La demanderesse a observé que la densité des trous dans la couche mince ou le caractère irrégulier du contour de la couche mince, tendait à croître avec le degré de recyclage du substrat donneur, c'est à dire le nombre de cycles de prélèvement - reconditionnement que ce substrat a subi.

Bien entendu, cette défectuosité n'est pas souhaitable et si elle excède un seuil spécifié, le substrat hybride composé de la couche mince et du support final ne peut être exploité. Dans le même temps, il est économiquement avantageux de pouvoir utiliser un même substrat donneur un grand nombre de fois, notamment lorsqu'un substrat donneur composite est exploité, car celui est bien plus onéreux à préparer comparativement au coût du reconditionnement d'un résidu.

### OBJET DE L'INVENTION

Un but de l'invention est de permettre l'utilisation d'un substrat donneur une pluralité de fois, cette utilisation multiple limitant toutefois la dégradation de la qualité de la couche mince prélevée et reportée tel que cela a été observé lorsque les procédés de l'état de la technique sont employés. L'invention trouve un intérêt tout particulier lorsque le substrat donneur est un substrat hybride, constitué d'une couche épaisse disposée sur un support intermédiaire.

### BREVE DESCRIPTION DE L'INVENTION

En vue de la réalisation de ce but, l'objet de l'invention propose un procédé de préparation du résidu d'un substrat donneur conforme à la revendication 1

Selon d'autres caractéristiques avantageuses et non limitatives de l'invention, prises seules ou selon toute combinaison techniquement réalisable :
- la deuxième étape de traitement est postérieure à la première étape d'enlèvement ;
- la première étape est mise en oeuvre par meulage de la couronne périphérique ;
- la deuxième étape est mise en oeuvre par polissage mécano-chimique de la surface principale ;
- l'épaisseur de la couche superficielle éliminée est inférieure à 5 microns ;
- l'attaque ionique comprend des ions d'argon ;
- la troisième étape de rectification vise à conformer la zone périphérique à un profil déterminé ;
- la zone périphérique présente, à l'issue de la troisième étape de rectification, une élévation maximale qui est inférieure ou égale à l'élévation d'un plan moyen d'élévation de la portion centrale ;
- le résidu comprend une couche épaisse de matériau disposé sur un support intermédiaire ;
- le matériau de la couche épaisse est un matériau ferroélectrique.
- la couche épaisse est assemblée au support intermédiaire par l'intermédiaire d'une couche d'un matériau adhésif.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1a]
   [Fig. 1b] La figure 1a et 1b représentent schématiquement un résidu d'un substrat donneur ;
[Fig. 2a] La figure 2a représente un résidu après l'application d'une première étape d'enlèvement d'un procédé de préparation conforme à l'invention ;
[Fig. 2b] La figure 2b représente un résidu après l'application d'une deuxième étape de traitement d'un procédé de préparation conforme à l'invention ;
[Fig. 2c] La figure 2c représente un résidu reconditionné après l'application d'un procédé de préparation conforme à l'invention ;
[Fig. 3] La figure 3 représente les étapes d'un procédé de prélèvement et de report d'une couche mince pouvant exploiter un résidu préparé selon l'invention.

### DESCRIPTION DETAILLEE DE L'INVENTION

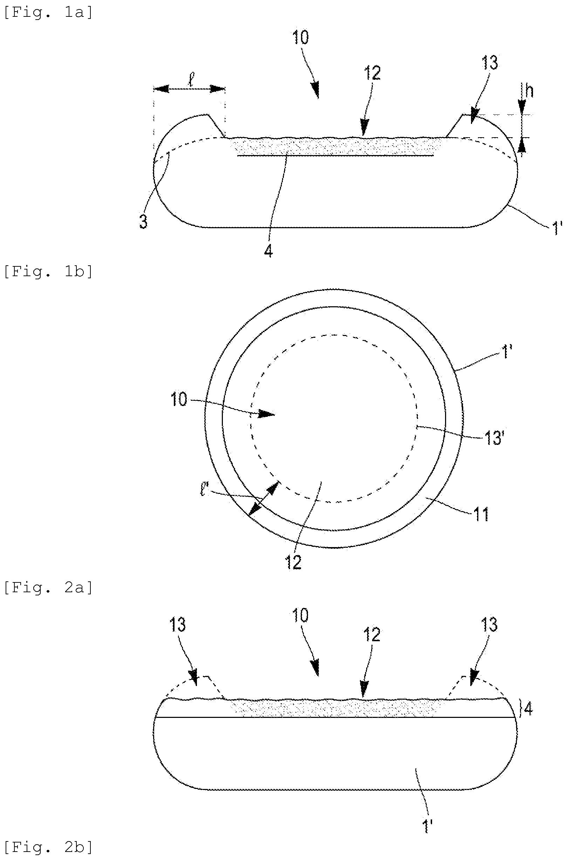

Les figures 1a et 1b représentent schématiquement un résidu 1' d'un substrat donneur, c'est-à-dire un substrat ayant subi le prélèvement d'une couche mince par délamination au niveau d'un plan fragile formé par l'introduction d'espèces légères, conformément aux étapes d'un procédé mettant en oeuvre la technologie Smart Cut.

Sur la face principale 10 de ce résidu 1', on retrouve une couronne périphérique 11, annulaire dans le cas de l'exemple représenté dans lequel le résidu 1' se présente sous la forme d'une plaquette circulaire, correspondant à une partie non prélevée du substrat donneur. Plus précisément, la couronne périphérique 11 réside dans une zone périphérique 13 du résidu 1' et correspond à la portion de la couche mince définie dans le substrat donneur qui n'est pas entrée en adhésion suffisante avec le support final lors de l'étape d'assemblage du procédé de report et qui, en conséquence, n'a pu être prélevée du substrat donneur. On observe sur la coupe de la figure 1a, sous la couronne périphérique 11, le plan fragile 3 définissant cette portion de couche mince non prélevée.

La couronne périphérique 11 forme une marche dont la largeur 1 peut être comprise entre 0,5 mm et 8 mm, et la hauteur h atteindre entre 100 nm et 1,5 micron. La zone périphérique présente, à la surface principale, une largeur l' supérieure à celle de la couronne, typiquement 1 à 3 fois la largeur l de la couronne, et plus généralement comprise entre 0,5mm et 2,5 cm. La présence de cette marche ne permet pas d'exploiter directement le résidu 1' pour en prélever une nouvelle couche mince. Par ailleurs, une portion centrale 12 de la surface principale 10, c'est à dire la surface contenue à l'intérieure de la couronne périphérique 11 de la zone périphérique 13, présente un état de surface particulièrement rugueux et une épaisseur superficielle écrouie, qu'il est également nécessaire de préparer avant une nouvelle utilisation du résidu 1'. Cet état de surface de la portion centrale 12 résulte de l'étape de prélèvement de la couche mince, la portion centrale 12 correspondant précisément au plan fragile P, créé par les espèces légères introduites dans le substrat donneur, le long duquel la couche mince a été prélevée.

La présente invention vise à reconditionner un tel résidu 1' pour le rendre apte à une nouvelle utilisation dans une application d'un procédé de prélèvement et de report d'une couche mince mettant en oeuvre le procédé Smart Cut. Plus précisément, la présente invention cherche à prévenir l'apparition de défauts de collage, ou à limiter la densité de ces défauts, en périphérie de l'interface formée de l'assemblage d'un substrat donneur reconditionné (plus précisément un résidu reconditionné d'un substrat donneur) à un support final.

Le procédé de préparation du résidu 1' comprend une première étape d'enlèvement d'une partie au moins de la couronne périphérique 11. Cette étape peut être mise en oeuvre par meulage (« grinding » selon le terme anglo-saxon usuellement employé dans le domaine de la fabrication des substrats). Dans un tel mode de mise en oeuvre, une roue d'un équipement de meulage est munie de particules abrasives (par exemple en diamant). Elle est positionnée contre la partie de la surface principale 10 du résidu à traiter, ici la couronne périphérique 11, et mise en rotation relativement au résidu de sorte à progressivement éliminer la matière constituant la couronne 11, par abrasion mécanique. Cet enlèvement conduit à exposer la zone périphérique 13 du résidu 1', comme cela est visible sur la figure 2a représentant le résidu après l'application de cette première étape d'enlèvement.

L'étape d'enlèvement peut mettre en oeuvre d'autres techniques que celle, préférée, de meulage. Il peut par exemple s'agir d'une technique de polissage, telle qu'un polissage mécano-chimique double face (« double side polish » selon l'expression anglo-saxonne consacrée).

A l'issue de cette première étape d'enlèvement, la couronne périphérique 11 est donc au moins partiellement éliminée, et la surface exposée 13 de la zone périphérique du résidu 1', peut présenter une élévation sensiblement identique à celle de la portion centrale 12 du résidu 1'. La zone périphérique 13 est également particulièrement rugueuse, notamment lorsque l'enlèvement de la couronne a été réalisé par meulage.

Aussi, le procédé de préparation du résidu 1' prévoit également une seconde étape au cours de laquelle on traite la face principale 10 du résidu 1', c'est à dire la portion centrale 12 et la zone périphérique 13 du résidu 1', pour en éliminer une couche superficielle 4. Cette couche superficielle 4 est suffisamment épaisse pour contenir l'épaisseur écrouie de la portion centrale 12 et d'une manière générale, pour fournir un état de surface de la surface principale suffisamment lisse pour permettre son assemblage par adhésion moléculaire à un support final. Cet état de surface peut être caractérisé par une rugosité inférieure à 0,5 nm (et avantageusement inférieure à 0,3 nm) en valeur quadratique moyenne sur un champ de mesure de 5 microns par 5 microns. Cette deuxième étape de traitement peut être mise en oeuvre par polissage mécano-chimique (« Chemical Mechanical Polishing » selon l'expression anglo-saxonne consacrée). L'épaisseur de la couche superficielle 4 éliminée peut ainsi être comprise entre 100 nm et 5 microns.

Lorsque la première étape d'enlèvement est distincte de la deuxième étape de traitement, cette dernière est réalisée postérieurement à l'étape d'enlèvement. Alternativement, ces deux étapes peuvent être mise en oeuvre de manière combinée par une technique de polissage mécano-chimique de la surface exposée du résidu.

On peut également envisager que ces deux étapes soient chacune réalisées par une technique de polissage mécano-chimique, mais chacune de ces étapes étant conduites avec des paramètres et/ou des consommables (notamment des tissus de polissage) distinct.

En tout état de cause, à l'issue de la seconde étape de traitement de la face principale 10 du résidu, et comme cela est représenté sur la figure 2b, on dispose d'un résidu 1' partiellement reconditionné, présentant une surface principale 10 suffisamment lisse et plane pour permettre son adhésion à un autre substrat par adhésion moléculaire.

Toutefois, une inspection attentive du résidu 1' à l'issue de la deuxième étape de traitement révèle qu'il présente une tombée de bord « remontante », c'est à dire que le profil d'élévation de la surface exposée de ce substrat, dans sa zone périphérique 13, présente un maximum M supérieur à l'élévation d'un plan moyen E de la partie de la portion centrale 12 de ce substrat, comprise à l'intérieure de la zone périphérique 13. Ce profil d'élévation de la surface périphérique 3 définissant la tombée de bord, peut être constaté en observant un profil d'élévation de la surface exposée élaboré selon plusieurs rayons distincts et, généralement, selon toutes les directions angulaires de ces rayons. Le point d'élévation maximum M de la zone périphérique peut ainsi s'élever jusqu'à 500nm au-dessus du plan moyen E du reste de la portion centrale 12 de ce substrat (i.e. la portion comprise à l'intérieure de la zone périphérique 13).

Cette tombée de bord « remontante » peut avoir de multiples causes. Elle peut être liée à un enlèvement imparfait de la couronne périphérique 11 au cours de la première étape du procédé. Mais elle peut être également liée, même lorsque la couronne périphérique a été parfaitement et entièrement éliminée au cours de cette première étape, à des effets de bord apparaissant au cours de la deuxième étape de traitement, notamment lorsque celle-ci est mise en oeuvre par polissage mécano-chimique.

On note que ce profil n'empêche pas un assemblage du résidu partiellement reconditionné de la figure 2b par adhésion moléculaire à un support final lors de l'application renouvelée du procédé de prélèvement et de report d'une couche mince. Sa surface est notamment suffisamment plane et lisse pour que les étapes de mise en contact et de propagation d'une onde de collage puissent être déployées. Toutefois, cette tombée de bord « remontante » tend à favoriser l'apparition des défauts de collage dont on a fait mention en introduction de cette demande.

Par ailleurs, l'amplitude de l'écart existant entre le maximum d'élévation M dans la zone périphérique 13 et l'élévation du plan moyen E de la portion centrale 12 tend à augmenter avec le degré de recyclage du substrat donneur, c'est à dire le nombre de cycles de prélèvement-reconditionnement opéré sur un même substrat donneur.

Aussi, pour prévenir ce phénomène et permettre la réutilisation d'un tel substrat donneur un grand nombre de fois (préférentiellement plus de 3 fois, ou 5 fois, voire même 10 fois), un procédé de préparation d'un résidu conforme à l'invention prévoit une troisième étape de rectification de la zone périphérique 13, succédant à la deuxième étape de traitement de la face principale 10, cette troisième étape visant à réduire l'élévation de cette zone périphérique.

Cette troisième étape est distincte de la première et de la troisième étape (et plus généralement ces trois étapes sont distinctes les unes des autres), c'est à dire qu'elles n'emploient pas les mêmes technologies et les mêmes équipements pour s'appliquer au résidu 1'.

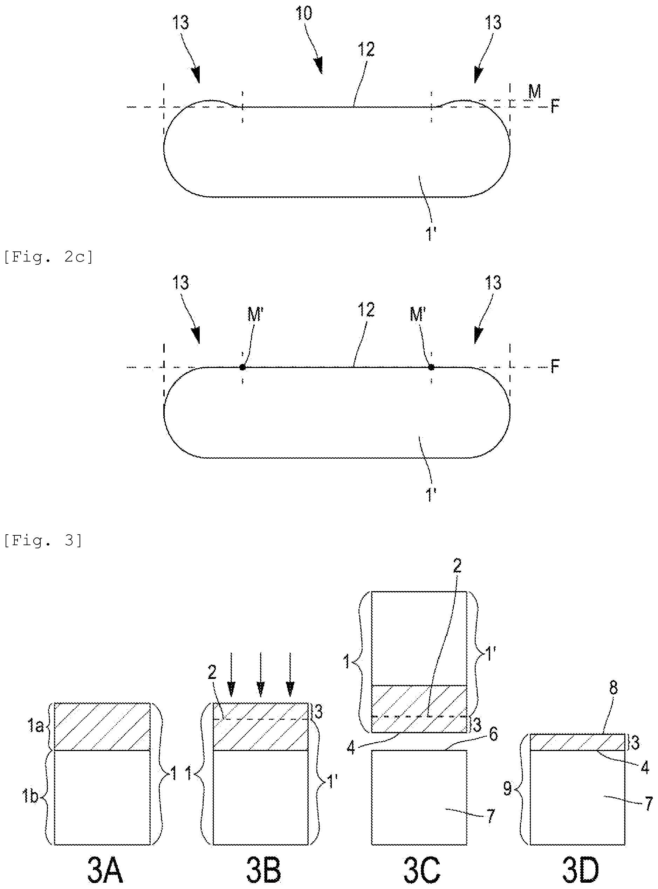

Avantageusement, à l'issue de la troisième étape, la zone périphérique 13 présente une élévation maximale M' qui est inférieure ou égale à l'élévation du plan moyen E de la portion centrale 12. Les expérimentations menées tendent à montrer que telle tombée de bord, présentant un profil « descendant » permet effectivement de réduire la défectivité de collage. La figure 2c représente le résidu 1' après lui avoir appliqué les 3 étapes qui viennent d'être décrite, dans la configuration avantageuse de l'étape de rectification selon laquelle la zone périphérique 13 présente une élévation maximale M' est inférieure ou égale à l'élévation du plan moyen E de la portion centrale 12.

On note qu'une simple diminution de l'élévation maximale M' de la zone périphérique par rapport à son élévation à l'issue de la deuxième étape, même restant supérieure à celle du plan moyen E, peut être suffisant pour contenir l'apparition croissante, avec le degré de recyclage, des défauts de collage. D'une manière très générale donc, cette troisième étape de rectification cherche à conformer la zone périphérique à un profil déterminé.

Pour permettre la rectification de la zone périphérique 13 avec la précision nécessaire, cette étape est avantageusement réalisée par une action non mécanique (plus précisément en l'absence de tout contact abrasif avec un outil extérieur) par attaque ionique (« ion beam trimming » ou « ion etching » selon les termes anglo-saxons du domaine).

Selon cette approche, on projette sur la zone périphérique 13 du résidu 1' des ions ou des amas d'ions avec une énergie suffisante, selon la nature du matériau dont est constitué le résidu 1', pour éroder peu à peu (au niveau atomique) une épaisseur superficielle de cette zone. Les ions sont avantageusement des ions lourds, tels que des ions d'argon, de néon ou de krypton.

Le faisceau d'ion est donc dirigé vers la zone périphérique 13 pour progressivement et avec grande précision conformer cette zone au profil déterminé. Le faisceau d'ions se projette sur une partie seulement de la zone périphérique 13, et on peut déplacer relativement le faisceau vis-à-vis du résidu pour traiter progressivement toute cette zone, le temps de passage du faisceau sur une partie de la zone déterminant la quantité de matière enlevée. On peut naturellement envisager d'effectuer plusieurs passages du faisceau.

On peut prévoir de placer un masque, par exemple en résine, en dehors de la zone périphérique 13 pour éviter de dégrader les caractéristiques de la zone centrale 12 lors de l'application de la troisième étape de rectification.

On peut prévoir une ou plusieurs étapes d'inspection du résidu 1', avant, en cours et/ou après la troisième étape de rectification de manière à relever le profil d'élévation de la zone périphérique 13 et de la zone centrale 12. On peut de la sorte ajuster les paramètres de l'attaque ionique pour effectivement contrôler et reproduire sur le résidu 1' le profil d'élévation déterminé.

Le substrat de la figure 2c obtenu à l'issue de l'application de la troisième étape de rectification, forme un résidu 1' reconditionné conforme à l'invention, qui peut donc servir de substrat donneur 1 dans l'application renouvelée d'un procédé de prélèvement et de report de couche mince.

### Exemple d'application

Cet exemple particulier vise généralement à former un substrat hybride 9 composé d'une couche mince ferromagnétique 3 reportée sur un support final 7 en silicium. Il est illustré sur la figure 3.

On réalise tout d'abord un substrat donneur composite 1 (étape 3A de la figure 3), formé d'un support intermédiaire 1b en silicium se présentant sous la forme d'une plaquette circulaire de 150 mm de diamètre, et d'une couche épaisse 1a, dont l'épaisseur peut être comprise entre 5 et 400 microns, d'un matériau ferroélectrique. Le matériau ferroélectrique formant la couche épaisse 1a est monodomaine, et constitué par exemple de LiTaO3, LiNbO3, LiAlO3, BaTiO3, PbZrTiO3, KNbO3, BaZrO3, CaTiO3, PbTiO3 ou de KTaO3. L'orientation cristalline de ce matériau est choisie en fonction de l'application visée. Ainsi, il est usuel de choisir une orientation comprise entre 30° et 60°RY, ou entre 40° et 50°RY, dans le cas où l'on souhaite exploiter les propriétés de la couche mince 3 reportée pour former un filtre SAW. Mais l'invention n'est nullement limitée à une orientation cristalline particulière.

Dans cet exemple, la couche épaisse 1a présente la même forme circulaire que le support intermédiaire et est sensiblement de la même dimension, si bien que le substrat donneur 1 présente une forme également circulaire de 150mm de diamètre. La réalisation précise de ce substrat donneur 1 peut suivre les enseignements fournis par le document US20200186117, cité en introduction de cette demande.

Ainsi, et selon une première approche, la couche épaisse 1a est assemblée à la plaquette de silicium formant le support intermédiaire 1b par adhésion moléculaire. On a pu prévoir d'insérer entre la plaquette de silicium 1b et la couche épaisse 1a, une couche facilitant cette adhésion (par exemple un oxyde ou un nitrure de silicium).

Selon une autre approche, la couche épaisse ferromagnétique 1a est maintenue sur la plaquette de silicium 1b par l'intermédiaire d'une couche d'un matériau adhésif, tel qu'un polymère.

On peut prévoir de rectifier le profil d'élévation de la surface libre de la couche épaisse ferromagnétique, tout comme cela a été proposé dans la troisième étape de rectification d'un résidu 1', pour donner un profil déterminé au substrat donneur, par exemple une tombée de bord « tombante » comme cela a été présenté antérieurement. On s'assure de la sorte de la qualité de collage lors de la première itération d'un procédé de prélèvement de couche.

Quelle que soit l'approche choisie pour assembler la couche épaisse ferromagnétique à la plaquette de silicium, le substrat donneur composite 1 est employé comme substrat donneur dans un procédé mettant en oeuvre la technologie Smart Cut. A cet effet, on introduit du côté de la face principale (la face exposée de la couche épaisse ferromagnétique 1a) du substrat composite 1 une dose d'espèce légère conduisant à former un plan fragile enterré 2 dans la couche épaisse 1a. Ce plan défini, avec la face principale du substrat donneur, la couche mince ferromagnétique 3 à prélever. La nature, la dose des espèces implantées et l'énergie d'implantation sont choisies en fonction de l'épaisseur de la couche mince que l'on souhaite transférer et des propriétés physico-chimiques de la couche épaisse 1a du substrat donneur 1. Dans le cas d'une couche épaisse en LiTaO3, on pourra ainsi choisir d'implanter une dose d'hydrogène comprise entre 1^{E}16 et 5^{E}17 at/cm² avec une énergie comprise entre 30 et 250keV pour délimiter une couche mince 3 de l'ordre de 200 à 1500 nm.

Dans une étape suivante 3C du procédé de prélèvement, on assemble par adhésion moléculaire la face principale de la couche épaisse 1a, avec une face exposée d'une plaquette de silicium de 150 mm de diamètre, similaire donc à la plaquette formant le support intermédiaire du substrat donneur 1. Cette plaquette forme le support final 7 de la couche mince 3. Comme on l'a déjà présenté dans l'introduction de cette demande, le substrat donneur 1 peut présenter une forme convexe, le sommet de la convexité tourné vers l'extérieur étant disposé du côté de la couche épaisse ferromagnétique. La flèche de cette convexité peut être de l'ordre de 200 microns, pour la plaquette de 150mm prise en exemple. En conséquence, le substrat donneur peut présenter un sommet sensiblement disposé au centre du substrat.

Au cours de l'étape d'assemblage, on met en contact le sommet du substrat donneur 1 avec le support final 7. On initie ensuite le collage en appliquant un effort sur le bord d'un des substrats tendant à les rapprocher l'un de l'autre. Cette application de l'effort engendre la propagation de l'onde de collage de manière sensiblement concentrique du sommet du substrat donneur 1 en contact avec le substrat final, vers le bord périphérique de ce substrat. Cette onde conduit à déformer les deux substrats 1, 7 pour que leurs surfaces entrent en contact intime l'une avec l'autre.

Dans une étape suivante 3D, l'ensemble formé du substrat donneur et du support final 7 est traité thermiquement et/ou mécaniquement pour provoquer la fracture du substrat donneur au niveau du plan fragile 2 pour délaminer la couche mince 1, la prélever et la reporter sur le support final 7.

On obtient ainsi, d'une part, un premier substrat hybride 9 formé de la couche mince ferromagnétique 3 prélevée de la couche épaisse 1a et de la plaquette de silicium formant le support final 7. D'autre part, on obtient également le résidu 1' conforme à celui de la figure 1.

Ce résidu 1' est préparé conformément aux étapes décrites dans la description générale précédente. Dans cet exemple précis, on élimine tout d'abord par meulage, au cours de la première étape d'enlèvement, la couronne périphérique 11, pour amener l'élévation de la zone périphérique 13 dans laquelle réside cette couronne 11 au niveau du plan moyen de la portion centrale 12. Puis on traite par polissage mécano-chimique toute la surface principale 10 du résidu, c'est à dire la portion centrale 12 et la zone périphérique 13, pour enlever jusque 1 micron d'une couche superficielle et réduire la rugosité de cette surface à moins de 0,3 nm en valeur quadratique moyenne. Enfin, on applique la troisième étape de rectification à la zone périphérique, ici sur une portion périphérique de 1 cm pris depuis le bord de la plaquette, en projetant un faisceau d'ion d'Argon afin de réduire l'élévation de cette portion périphérique.

A l'issue de ces étapes, le résidu 1' est parfaitement reconditionné. Outre une rugosité de surface compatible avec une étape d'assemblage par adhésion moléculaire, il présente une tombée de bord « tombante », c'est à dire que l'élévation maximale dans la zone périphérique 13 se situe dans ou sous le plan moyen d'élévation de la portion centrale 12.

Dans un cycle suivant d'exploitation de ce substrat reconditionné, on réapplique des cycles de prélèvement-reconditionnement qui viennent d'être présentées pour fournir une pluralité de substrats hybrides 9 comportant chacun une couche mince ferromagnétique 3 disposée sur une plaquette de silicium 7. Le nombre de cycles est limité par l'épaisseur restante de couche épaisse 1a du substrat donneur composite 1, il peut atteindre et voire dépasser 10 cycles, si la couche épaisse 1a est initialement suffisamment épaisse, par exemple présenter une épaisseur proche de 400 microns.

On observe que les substrats hybrides 9 obtenus successivement présentent des niveaux de défectivité (notamment issu de défaut de collage en bords des substrats) qui n'est pas nécessairement croissant avec le nombre de cycles, c'est à dire avec le degré de recyclage du substrat donneur composite.

Bien entendu l'invention n'est pas limitée aux modes de mise en oeuvre et à l'exemple décrits et on peut y apporter des variantes de réalisation sans sortir du cadre de l'invention tel que défini par les revendications.

Ainsi, l'invention s'applique à tout type de substrat donneur ayant subi un prélèvement d'une couche par délamination au niveau d'un plan fragile formé par introduction d'espèces légères. Il n'est pas nécessaire que ce substrat donneur soit du type « composite », formé d'une couche épaisse reposant sur un substrat intermédiaire.

Ce substrat donneur peut également être de toute nature compatible avec ce type de prélèvement de couche. Il peut notamment être composé de tout matériau semi-conducteur, par exemple en silicium, en carbure de silicium, en germanium, etc.

Les substrats peuvent d'une manière générale se présenter sous toute forme qui convient, et l'invention n'est nullement limitée à des plaquettes circulaires comme cela a été pris à titre d'exemple.

## Revendications

1. Procédé de préparation du résidu (1') d'un substrat donneur (1), le substrat donneur (1) ayant subi un prélèvement d'une couche mince (3) par délamination au niveau d'un plan fragile (2) formé par introduction d'espèces légères, le résidu (1') comprenant, sur une zone périphérique (13) d'une face principale (10), une couronne périphérique (11) correspondant à une partie non prélevée du substrat donneur (1), et le procédé comprenant :
- une première étape d'enlèvement d'une partie au moins de la couronne périphérique (11);
- une deuxième étape de traitement de la face principale (10) du résidu (1') visant à éliminer une couche superficielle (4);
ledit procédé étant **caractérisé en ce qu'**il comprend:
- une troisième étape de rectification par attaque ionique, postérieure à la deuxième étape, de la zone périphérique (13) de la face principale (10) du résidu (1'), la troisième étape de rectification visant à réduire l'élévation de la zone périphérique (13).

2. Procédé de préparation selon la revendication précédente dans lequel la deuxième étape de traitement est postérieure à la première étape d'enlèvement.

3. Procédé de préparation selon l'une des revendications précédentes dans lequel la première étape est mise en oeuvre par meulage de la couronne périphérique (11).

4. Procédé de préparation selon l'une des revendications précédentes dans lequel la deuxième étape est mise en oeuvre par polissage mécano-chimique de la surface principale (10) .

5. Procédé de préparation selon l'une des revendications précédentes dans lequel l'épaisseur de la couche superficielle (4) éliminée est inférieure à 5 microns.

6. Procédé de préparation selon l'une des revendications précédentes dans lequel l'attaque ionique comprend des ions d'argon.

7. Procédé de préparation selon l'une des revendications précédentes dans lequel la troisième étape de rectification vise à conformer la zone périphérique (13) à un profil déterminé.

8. Procédé de préparation selon l'une des revendications précédentes dans lequel la zone périphérique (13) présente, à l'issue de la troisième étape de rectification, une élévation maximale (M') qui est inférieure ou égale à l'élévation d'un plan moyen d'élévation (E) de la portion centrale (12).

9. Procédé de préparation selon l'une des revendications précédentes dans lequel le résidu (1') comprend une couche épaisse (1a) de matériau disposé sur un support intermédiaire (1b).

10. Procédé de préparation selon la revendication précédente dans lequel le matériau de la couche épaisse (1a) est un matériau ferroélectrique.

11. Procédé de préparation selon l'une des deux revendications précédentes dans lequel la couche épaisse (1a) est assemblée au support intermédiaire par l'intermédiaire d'une couche d'un matériau adhésif.

## Patentansprüche

1. Verfahren zum Herstellen des Rückstands (1') eines Donorsubstrats (1), wobei das Donorsubstrat (1) einer Entnahme einer Dünnschicht (3) durch Delamination an einer zerbrechlichen Ebene (2) unterzogen wurde, die durch Einführen leichter Spezies ausgebildet wird, der Rückstand (1') umfassend, auf einer Umfangszone (13) einer Hauptfläche (10), einen Umfangsring (11), der einem nicht entnommenen Teil des Donorsubstrats (1) entspricht, und das Verfahren umfassend:
- einen ersten Schritt eines Entfernens mindestens eines Teils des Umfangsrings (11);
- einen zweiten Schritt eines Behandelns der Hauptfläche (10) des Rückstands (1'), der darauf abzielt, eine Oberflächenschicht (4) zu beseitigen;
wobei das Verfahren **dadurch gekennzeichnet ist, dass** es umfasst:
- einen dritten Schritt eines Rektifizierens durch lonenätzen nach dem zweiten Schritt der Umfangszone (13) der Hauptfläche (10) des Rückstands (1'), wobei der dritte Schritt des Rektifizierens darauf abzielt, die Höhe der Umfangszone (13) zu reduzieren.

2. Herstellungsverfahren nach dem vorstehenden Anspruch, wobei der zweite Schritt des Behandelns nach dem ersten Schritt des Entfernens ist.

3. Herstellungsverfahren nach einem der vorstehenden Ansprüche, wobei der erste Schritt durch Schleifen des Umfangsrings (11) erfolgt.

4. Herstellungsverfahren nach einem der vorstehenden Ansprüche, wobei der zweite Schritt durch mechanisch-chemisches Polieren der Hauptoberfläche (10) erfolgt.

5. Herstellungsverfahren nach einem der vorstehenden Ansprüche, wobei die Dicke der beseitigten Oberflächenschicht (4) weniger als 5 Mikrometer beträgt.

6. Herstellungsverfahren nach einem der vorstehenden Ansprüche, wobei das lonenätzen Argonionen umfasst.

7. Herstellungsverfahren nach einem der vorstehenden Ansprüche, wobei der dritte Schritt des Rektifizierens darauf abzielt, die Umfangszone (13) an ein bestimmtes Profil anzupassen.

8. Herstellungsverfahren nach einem der vorstehenden Ansprüche, wobei die Umfangszone (13) am Ende des dritten Schritts des Rektifizierens eine maximale Höhe (M') aufweist, die kleiner als oder gleich der Höhe einer Höhenmittelebene (E) des zentralen Abschnitts (12) ist.

9. Verfahren nach einem der vorstehenden Ansprüche, wobei der Rückstand (1') eine dicke Schicht (1a) aus Material umfasst, das auf einem Zwischenträger (1b) angeordnet ist.

10. Herstellungsverfahren nach dem vorstehenden Anspruch, wobei das Material der dicken Schicht (1a) ein ferroelektrisches Material ist.

11. Herstellungsverfahren nach einem der zwei vorstehenden Ansprüche, wobei die dicke Schicht (1a) mittels einer Schicht aus einem Klebematerial mit dem Zwischenträger verbunden wird.

## Claims

1. A method for preparing the residue (1') of a donor substrate (1), a thin layer (3) having been removed from the donor substrate (1) by delamination at a fragile plane (2) formed by introduction of light species, the residue (1') comprising, on a peripheral region (13) of a main face (10), a peripheral ring (11) corresponding to a non-removed part of the donor substrate (1), and the method comprising:
- a first step of removing at least a part of the peripheral ring (11);
- a second step of treating the main face (10) of the residue (1') to remove a surface layer (4);
the method being **characterized in that** it comprises:
- a third step, subsequent to the second step, of grinding by ion etching the peripheral region (13) of the main face (10) of the residue (1'), the third grinding step aiming to reduce the elevation of the peripheral region (13).

2. The preparation method according to the preceding claim, wherein the second treatment step is subsequent to the first removal step.

3. The preparation method according to any of the preceding claims, wherein the first step is performed by milling the peripheral ring (11).

4. The preparation method according to any of the preceding claims, wherein the second step is performed by chemical-mechanical polishing of the main surface (10).

5. The preparation method according to any of the preceding claims, wherein the thickness of the removed surface layer (4) is less than 5 microns.

6. The preparation method according to any of the preceding claims, wherein the ion etching comprises ion etching with argon ions.

7. The preparation method according to any of the preceding claims, wherein the third grinding step aims to shape the peripheral region (13) to a determined profile.

8. The preparation method according to any of the preceding claims, wherein the peripheral region (13) has, on completion of the third grinding step, a maximum elevation (M') that is less than or equal to the elevation of a mean elevation plane (E) of the central portion (12).

9. The preparation method according to any of the preceding claims, wherein the residue (1') comprises a thick layer (1a) of material arranged on an intermediate support (1b).

10. The preparation method according to the preceding claim, wherein the material of the thick layer (1a) is a ferroelectric material.

11. The preparation method according to any of the two preceding claims, wherein the thick layer (1a) is joined to the intermediate support by means of a layer of an adhesive material.
